Europäisches Patentamt

European Patent Office

Office européen des brevets

(11) Veröffentlichungsnummer : **0 023 935**
**B1**

(12) **EUROPÄISCHE PATENTSCHRIFT**

(45) Veröffentlichungstag der Patentschrift :
24.11.82

(51) Int. Cl.³ : **G 01 D   3/08**, G 01 R  17/02,
G 01 R  31/00

(21) Anmeldenummer : 79200435.0

(22) Anmeldetag : 08.08.79

(54) Einrichtung zur ständigen Funktionskontrolle eines Anzeige- oder Registrierinstrumentes, Verfahren zum Betreiben derselben sowie Anwendung des Verfahrens.

(43) Veröffentlichungstag der Anmeldung :
18.02.81 (Patentblatt 81/07)

(45) Bekanntmachung des Hinweises auf die Patenterteilung : 24.11.82 Patentblatt 82/47

(84) Benannte Vertragsstaaten :
DE FR IT

(56) Entgegenhaltungen :
GB A 1 160 990

(73) Patentinhaber : Hasler AG
Belpstrasse 23
CH-3000 Bern 14 (CH)

(72) Erfinder : Winkler, Erhard
Senseblickstrasse 4
CH-3174 Thörishaus (CH)

(74) Vertreter : Schwerdtel, Eberhard, Dr.
c/o Hasler AG Belpstrasse 23
CH-3000 Bern 14 (CH)

Einrichtung zur ständigen Funktionskontrolle eines Anzeige- oder Registrierinstrumentes, Verfahren zum Betreiben derselben sowie Anwendung des Verfahrens.

Die Erfindung betrifft eine Einrichtung zur ständigen Funktionskontrolle eines Anzeige- oder Registrierinstrumentes, dessen als Antrieb dienender elektromechanischer Wandler die bewegliche Anzeige- bzw. Registriereinheit des Instrumentes laufend auf einen Anzeigewert einstellt, der dem jeweiligen Wert eines elektrischen Eingangssignals entspricht. Weiter betrifft die Erfindung ein Verfahren zum Betreiben der Einrichtung und eine Anwendung des Verfahrens.

Elektromechanische Anzeige- und/oder Registriergeräte sind allgemein bekannt. Sie weisen die verschiedensten elektromechanischen Antriebe auf, beispielsweise Drehspulantriebe, Wirbelstromantriebe, Servoantriebe usw. Aus der deutschen Offenlegungsschrift 26 11 618 ist eine Schaltungsanordnung bekannt, die bei einem Instrument mit Servo-Regelkreis eine Fehleranzeige bewirkt, wenn die Servo-Rückführspannung nicht mit der Eingangsspannung übereinstimmt. Hierzu besitzt die Anordnung einen Verstärker, der unabhängig vom Servo-Verstärker mit der Eingangsspannung und der Rückführspannung gespeist wird. Ein nachfolgender Fensterdiskriminator sorgt dafür, dass ein Alarmsignal abgegeben wird, wenn die Abweichungen zwischen den beiden genannten Spannungen grösser als die durch das Fenster des Diskriminators vorgegebene Spanne sind. Hiermit erlaubt die Anordnung die ständige Ueberwachung des Servoantriebes. Auf Ausfall der Betriebsspannung reagiert die Anordnung ebenfalls durch Ansprechen einer zusätzlichen Einrichtung.

Die Anordnung erlaubt zwar eine ständige Kontrolle des Servoantriebes, ermöglicht aber nicht die Feststellung eines Fehlers in der Rückmeldespannung. Hierdurch kann es passieren, dass die Anzeige nicht mit dem Eingangssignal übereinstimmt und trotzdem ordnungsgemässes Arbeiten vorgetäuscht wird. Weiter benötigt die Anlage eine Verzögerungseinrichtung, wenn schnelle Aenderungen auf der Eingangsleitung auftreten, da der Servoantrieb nur mit einer gewissen Verzögerung nachfolgen kann.

Die Aufgabe der vorliegenden Erfindung besteht darin, eine Einrichtung zur ständigen Funktionskontrolle eines Anzeige- oder Registrierinstrumentes anzugeben, wobei die Funktionskontrolle unabhängig von der Art der Eingangssignale und unabhängig von der Art des Instrumentenantriebes ist. Weiter soll das System vollständige Sicherheit der Fehleranzeige bieten. Die Einrichtung zur Lösung dieser Aufgabe ist gekennzeichnet durch eine mit der Anzeige- bzw. Registriereinheit mechanisch gekoppelte, vom elektromechanischen Wandler elektrisch unabhängige Gebereinheit zum Erzeugen eines dem Anzeigewert entsprechenden Gebersignals, und durch eine fehlerüberwachte Vergleichsschaltung zum laufenden Vergleichen des Gebersignals mit einem Bezugssignal und zur Abgabe eines Alarmsignals bei Nichtübereinstimmung des Geber- und des Bezugssignals.

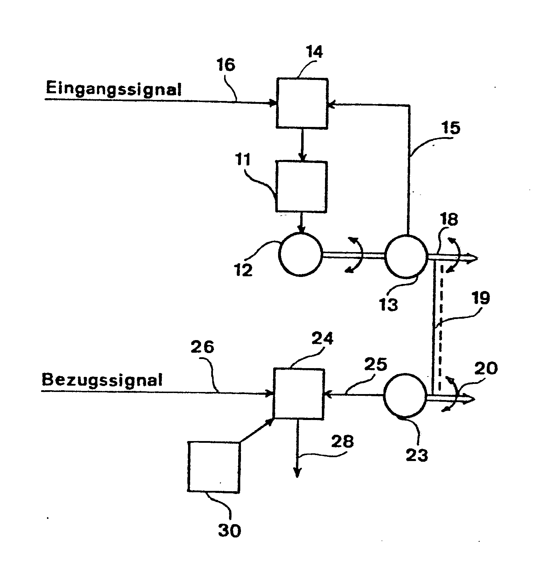

Im folgenden wird die Erfindung anhand einer einzigen Figur, die ein Blockschaltbild der Einrichtung darstellt, beispielsweise näher erläutert.

Die Einheiten 11, 12, 13 und 14 bilden ein Servo-System. 11 ist eine Motorsteuerung, die einen Motor 12 zum Antrieb einer Rolle 18 steuert, und zwar vorwärts oder rückwärts je nach den Gegebenheiten. 13 ist ein Stellungsgeber, der wie die Rolle 18 starr mit dem Motor 12 gekoppelt ist und jeweils angibt, welche Position die Anzeigeeinheit einnimmt. Ueber die Leitung 15 wird diese Position zum Vergleicher 14 rückgemeldet. Der Vergleicher 14 vergleicht ständig dieses Rückmeldesignal auf Leitung 15 mit dem Eingangssignal auf Leitung 16. Solange die beiden Signale nicht übereinstimmen, gibt er ein Steuersignal an die Motorsteuerung 11 ab. Hierdurch dreht der Motor 12 solange, bis die Signale auf den Leitungen 15 und 16 übereinstimmen. Hiermit ist die jeweilige Endposition erreicht, die dem Eingangssignal auf Leitung 16 entspricht.

18, 19 und 20 sind Untereinheiten einer Bandanzeigeeinheit, wie sie beispielsweise in Hasler Mitteilungen 32 (1973) Nr. 1/2, Seite 6-23 eingehend geschildert ist. 19 ist das Band dieser Anzeigeeinheit, welches zwischen der Antriebsrolle 18 und wenigstens einer Umlenkrolle 20 beweglich und federnd aufgespannt ist. Das Band 19 ist mit Zeichen, Skalenstrichen und/oder einer farbigen Markierung versehen und bewegt sich parallel zu einem in der Figur nicht dargestellten Sichtfenster. Die Scheibe des Sichtfensters trägt eine Skala oder wenigstens einen Markierungsstrich. Damit ersetzen das Band 19 und das Sichtfenster den Zeiger und die Skala üblicher Rundinstrumente.

Während Zeiger von Rundinstrumenten im allgemeinen starr mit der Achse verbunden sind, und somit kaum eine Gefahr einer Winkelverschiebung zwischen Achse und Zeiger besteht, bildet das Band 19 eine empfindliche Baugruppe des Anzeigeinstrumenstes. Das Band kann auf der Rolle 18 rutschen oder, sich dehnen und so eine fehlerhafte Anzeige bewirken. Weiter besteht die Gefahr des Reissens. Hierdurch wird im allgemeinen die Anzeige unmöglich. Durch Verklemmen des Bandes kann jedoch weiterhin eine feststehende Anzeige vorgetäuscht werden. Die Aufgabe besteht daher darin, diese Bandanzeigeeinheit sicher zu überwachen.

Auf der Achse der Rolle 20 befindet sich zu diesem Zweck ein zweiter Stellungsgeber 23, der mit dem Stellungsgeber 13 baugleich oder ungleich sein kann. Bei rutschfreier Kopplung des Bandes 19 und der beiden Rollen 18 und 20 nimmt der Stellungsgeber 23 stets die gleiche Position wie der Stellungsgeber 13 ein. 24 ist ein Vergleicher, der gleich oder ähnlich wie der Vergleicher 14 aufgebaut ist. Er vergleicht die Signale des Stellungsgebers 23, die auf Leitung 25 anliegen und ein Bezugssignal, welches über Leitung 26 eingegeben wird. Solange diese beiden Signale gleich sind oder nur geringfügig voneinander abweichen, gibt er ein Ueberwachungssignal ab, welches das ordnungsgemässe Arbeiten des gesamten Ueberwachungsbereichs bescheinigt. Sobald die Signale auf den Leitungen 25 und 26 jedoch stärker voneinander abweichen, entsteht ein Alarmsignal, welches über die Leitung 28 abgegeben wird.

Da Fehler, die im Vergleicher 24 auftreten, ebenfalls stets erkennbar sein müssen, wird der Vergleicher über eine Einrichtung 30 ständig auf einwandfreies Arbeiten überprüft. Eine solche Einrichtung 30 ist beispielsweise in der schweizerischen Patentschrift 518 036 beschrieben und arbeitet nach dem Prinzip der Weitergabe eines dynamischen Signals, welches nicht weitergegeben wird, sobald Fehler in der zu prüfenden Einheit auftreten.

Die Funktionskontroll-Einrichtung arbeitet nur dann einwandfrei, wenn sowohl alle Teile ordnungsgemäss arbeiten als auch die Eingangssignale auf Leitung 16 und die Bezugssignale auf Leitung 26 ordnungsgemäss übereinstimmen. Dies kann im Sinne der eingangs zitierten Offenlegungsschrift 26 11 618 dadurch erfolgen, dass das Bezugssignal vom Eingangssignal abgeleitet wird. Im Sinne der vorliegenden Erfindung ist es jedoch wesentlich besser, wenn als Bezugssignal ein vollkommen unabhängiges Signal verwendet wird.

Wird das Anzeigeinstrument in einem Triebfahrzeug für schienengebundene Fahrzeuge verwendet, d.h. beispielsweise in einer Lokomotive, so können das Eingangssignal und das Bezugssignal von unabhängigen Rad- bzw. Achsabnehmern der gleichen oder verschiedener Achsen abgeleitet werden. Hierdurch entsteht ein Ueberwachungssytem, welches sowohl die Funktionsfähigkeit des gesamten Anzeigeinstrumentes sowie u.U. den Gleichlauf der Achsen, aus denen die Eingangs- und Bezugssignale gewonnen werden, überwacht. Die Funktionskontroll-Einrichtung spricht an auf alle Fehler im Servo-System, auf Leitungsbrüche, auf Riss des Anzeigebandes 19, auf Funktionsunfähigkeit der Stellungsgeber 13 und 23, usw. Es bildet damit ein fehlergesichertes (fail safe) System.

Die Funktionskontroll-Einrichtung kann sowohl mit analogen als auch mit digitalen sowie mit gemischt-digital/analogen Signalen arbeiten. Dies bedeutet, dass die Vergleicher 14 und 24 entweder als digitale Logik oder als Analogschaltung ausgebildet sind und dass die Stellungsgeber 13 und 23 entsprechend Winkelcodier-Vorrichtungen oder Drehpotentiometer sind.

Der Antrieb mit Hilfe des Motors 12 wurde als Servo-Antrieb geschildert. Die Funktionskontroll-Einrichtung arbeitet jedoch auch dann einwandfrei, wenn andere elektromagnetische Antriebe wie beispielsweise Drehspulantriebe, Wirbelstromantriebe oder ähnliches zum Antrieb der Anzeigeeinheit verwendet werden.

Benutzt wird die Anzeigeeinheit in Triebfahrzeugen von schienengebundenen Fahrzeugen, beispielsweise Lokomotiven, wobei mehrere Bänder zu einer Sicht- und Kontrolleinheit kombiniert werden können. Sinnvoll ist die Kombination der Anzeige der Ist- und der Sollgeschwindigkeit sowie der Anzeige der Zieldistanz bzw. des Restbremsweges.

**Ansprüche**

1. Einrichtung zur ständigen Funktionskontrolle eines Anzeige- oder Registrierinstrumentes, (18-20), dessen als Antrieb dienender elektromechanischer Wandler (12) die bewegliche Anzeige- bzw. Registriereinheit des Instrumentes laufend auf einen Anzeigewert einstellt, der dem jeweiligen Wert eines elektrischen Eingangssignals entspricht, gekennzeichnet durch eine mit der Anzeige- bzw. Registriereinheit mechanisch gekoppelte, vom elektromechanischen Wandler (12) elektrisch unabhängige Gebereinheit (23) zum Erzeugen eines dem Anzeigewert entsprechenden Gebersignals, und durch eine fehlerüberwachte Vergleichsschaltung (24) zum laufenden Vergleichen des Gebersignals mit einem Bezugssignal und zur Abgabe eines Alarmsignals bei Nichtübereinstimmung des Geber- und des Bezugssignals.

2. Einrichtung nach Anspruch 1, wobei das Anzeige- oder Registrierinstrument (18-20) ein Bandanzeigeinstrument ist, welches als bewegliche Anzeigeeinheit ein mit Zeichen versehenes Band (19) aufweist, das längs eines Sichtfensters durch wenigstens zwei Rollen (18 ; 20) geführt wird, dadurch gekennzeichnet, dass der elektromechanische Wandler (12) mit einer ersten (18) dieser Rollen und die Gebereinheit (23) mit einer zweiten (20) dieser Rollen mechanisch verbunden ist.

3. Verfahren zum Betreiben der Einrichtung nach Anspruch 1, dadurch gekennzeichnet, dass das Bezugssignal elektrisch unabhängig vom Eingangssignal gewonnen wird.

4. Anwendung des Verfahrens nach Anspruch 3 mit einer Einrichtung nach Anspruch 1 als Geschwindigkeitsanzeigegerät für Bahnfahrzeuge, dadurch gekennzeichnet, dass das Eingangs- und das Bezugssignal von zwei von einander unabhängigen Achsabnehmern des Bahnfahrzeugs abgeleitet werden.

**Claims**

1. Device for continuously controlling the functioning of a display or recording instrument (18-20) with an electro-mechanical converter (12), serving as a driver, which continuously sets the movable display or recording unit of the instrument to a displayed-value corresponding to the current value of an electrical input signal, characterized by a sensor unit (23) used for the generation of a positional signal proportional the displayed-value, which sensor unit (23) is mechanically coupled to the display or recording unit and electrically independent of the electro-mechanical converter (12), and by an error-monitored comparator circuit (24) for continuous comparison of the positional signal with a reference signal and for issuing an alarm signal if the positional signal and the reference signal are not consistent.

2. Device according to Claim 1, whereby the display or recording instrument (18-20) is a strip display instrument, which has as the movable display unit a strip (19) upon which numbers are marked and which is guided across a viewing window by at least two rollers (18, 20), wherein, the electro-mechanical converter (12) is connected to a first of these rollers (18) and the sensor unit (23) is connected to a second of these rollers (20).

3. Method for operation of the device in accordance with Claim 1, wherein the reference signal and the input signal are derived from electrically independent sources.

4. Application of the method according to Claim 3 with a device according to Claim 1 and used as a speed indicator device for railway vehicles, characterised by the input signal and the reference signal being obtained from two mutually independent axle pick-up units of the railway vehicles.

**Revendications**

1. Dispositif pour le contrôle permanent du fonctionnement d'un instrument d'affichage ou d'enregistrement (18-20) dont le transformateur électromécanique (12) servant de commande ajuste en permanence l'ensemble mobile d'affichage ou d'enregistrement de l'instrument à une valeur d'affichage qui correspond à la valeur à un instant donné d'un signal électrique d'entrée, et caractérisé par un ensemble transmetteur (23) électriquement indépendant du transformateur électromécanique (12) relié mécaniquement à l'instrument d'affichage ou d'enregistrement (18-20) pour émettre un signal correspondant à la valeur d'affichage, et par un montage comparateur (24) surveillé pour éviter les erreurs et destiné à comparer continuellement le signal précité avec un signal de référence et à émettre un signal d'alarme dans le cas où le signal précité et le signal de référence ne sont pas en phase.

2. Dispositif suivant la revendication 1, dans lequel l'instrument d'affichage ou d'enregistrement (18-20) est un indicateur à bande qui possède comme unité mobile d'affichage une bande (19) munie de repères qui est guidée le long d'un voyant par au moins deux poulies (18, 20), et caractérisé en ce que le transformateur électromécanique (12) est relié mécaniquement à une première, (18) , de ces poulies, et que l'ensemble émetteur (23) est relié mécaniquement à une seconde, (20), de ces poulies.

3. Procédé pour actionner le dispositif suivant la revendication 1, caractérisé en ce que le signal de référence est obtenu électriquement indépendamment du signal d'entrée.

4. Utilisation du procédé suivant la revendication 3 avec un dispositif suivant la revendication 1 comme indicateur de vitesse pour des véhicules ferroviaires, caractérisé en ce que le signal d'entrée et le signal de référence sont dérivés de deux dispositifs indépendants l'un de l'autre montés sur l'axe du véhicule.

Eingangssignal

Bezugssignal